# EUROPÄISCHE PATENTSCHRIFT

(11) **EP 3 345 229 B1**
(45) Veröffentlichungstag und Bekanntmachung des Hinweises auf die Patenterteilung: **05.07.2023**
(21) Anmeldenummer: 16759730.1
(22) Anmeldetag: 29.08.2016
(51) Int. Cl.: B32B 3/08, B32B 3/26, B32B 5/12, B32B 5/26, B32B 7/12

(54) **ANORDNUNG UND VERFAHREN ZUR BEEINFLUSSUNG UND/ODER DETEKTION EINER DYNAMISCHEN ODER STATISCHEN EIGENSCHAFT EINER TRAGSTRUKTUR**
ARRANGEMENT AND METHOD FOR INFLUENCING AND/OR DETECTING A DYNAMIC OR STATIC PROPERTY OF A SUPPORT STRUCTURE
ENSEMBLE ET PROCÉDÉ PERMETTANT D'AGIR SUR ET/OU DE DÉTECTER UNE CARACTÉRISTIQUE DYNAMIQUE OU STATIQUE D'UNE STRUCTURE SUPPORT

(30) Priorität: 03.09.2015 DE 102015216846
(43) Veröffentlichungstag der Anmeldung: 11.07.2018
(73) Patentinhaber: Fraunhofer-ges. zur Förderung der Angewandten Forschung E.V., 80686 München (DE)
(72) Erfinder: MAYER, Dirk, 64295 Darmstadt (DE); SALLOUM, Rogério, Singapore 573963 (SG)
(74) Vertreter: Rösler, Uwe
(86) Internationale Anmeldenummer: PCT/EP2016/070299
(87) Internationale Veröffentlichungsnummer: WO 2017/037007

(56) Entgegenhaltungen:
- US-A- 5 552 656
- US-A1- 2008 202 664
- DATABASE WPI Week 201426 Thomson Scientific, London, GB; AN 2014-G25483 XP002764667, -& CN 103 591 972 A (UNIV JINAN) 19. Februar 2014 (2014-02-19)

## Beschreibung

### Technisches Gebiet

Die Erfindung bezieht sich auf eine Anordnung zur Beeinflussung und/oder Detektion einer dynamischen oder statischen Eigenschaft einer Tragstruktur, die über eine Tragstrukturoberfläche verfügt, mit zumindest einem flächig ausgebildeten ersten Aktorelement, das wenigstens ein elektrisch und/oder magnetisch aktivierbares Wandlermaterial aufweist, sowie einem das erste Aktorelement flächig mittel- oder unmittelbar an die Tragstrukturoberfläche fügenden Faserverbundwerkstoff, der zumindest eine erste Faserschicht sowie eine aushärtbare Matrix aufweist.

### Stand der Technik

Gattungsgemäße Anordnungen der vorstehenden Art dienen bspw. der kontrollierten Beeinflussung des Bewegungs- bzw. Schwingungsverhaltens eines beliebigen Bauteils bzw. einer beliebigen Bauteilgruppe oder Komponenten aus dem Bereich des Maschinen- und Gerätebaus. Zu Zwecken einer gezielten Einflussnahme auf das dynamische Verhalten eines Bauteils werden Wandlermaterial-inhärente Transformationseigenschaften genutzt, die eine Umwandlung von elektrischen bzw. magnetischen Signalen in Geometrieänderungen und damit verbunden in mechanisch wirksame bzw. nutzbare Stellwegänderungen, im Falle von piezoelektrischen, elektrostriktiven oder magnetostriktiven Materialien, und umgekehrt ermöglichen. Diese im Weiteren kurz als Aktorelemente bezeichneten Wandler sind mit dem jeweiligen Bauteil fest verbunden, so dass eine möglichst direkte Kraftkopplung zwischen dem Aktorelement und der Oberfläche des Bauteils, im Weiteren als Tragstrukturoberfläche bezeichnet, gegeben ist.

Unter der Vielzahl geeigneter elektrischer sowie auch magnetischer Wandlermaterialien sind Aktorelemente mit bzw. aus piezoelektrischem Material sowohl für aktorische als auch sensorische Aufgaben weit verbreitet. Derartige Aktorelemente, die als "Piezoaktoren" bezeichneten werden, stellen flächig bzw. plättchenförmig ausgebildete, aus piezoelektrischem Material bestehende Elemente dar, die durch Applikation einer elektrischen Spannung ihre Raumform ändern und somit im Wege eines festen Fügeverbundes mit der Tragstruktur Kräfte in diese einzuleiten vermögen. Gleichsam eignen sich derartige strukturintegrierte bzw. - applizierte Aktorelemente beispielsweise auch zur Schadensdetektion durch Analyse der Wechselwirkung von in die Tragstruktur eingekoppelter elastischer Wellen mit innerhalb der Tragstruktur vorhandenen Strukturschäden. Im letzteren Fall dient das Aktorelement zugleich auch als Sensorelement, das im Wege einer auf das piezoelektrische Material einwirkenden äußeren Deformation zur Schwingungsanalyse auswirkbare elektrische Signale erzeugt.

Je nach Form, Größe und Gewicht der dynamisch zu beeinflussenden Tragstruktur sowie der mit Hilfe des auf die Tragstruktur applizierten Aktorelementes gewünschten dynamischen Wirkung werden entsprechend viele bzw. groß dimensionierte Aktorelemente lokal an die Oberfläche einer Tragstruktur fest gefügt, um Biegemomente zu generieren, durch die die Tragstruktur gezielt elastisch verformt wird.

Aus der Druckschrift DE 100 51 784 C1 geht ein elektromechanisches Funktionsmodul hervor, das eine Vielzahl laminierter Fasergewebeschichten aufweist, zwischen bzw. in den einzelnen Fasergewebeschichten in vertikaler Abfolge übereinander piezoelektrische, scheibenförmig ausgebildete Aktorelemente eingebettet sind. Das elektromechanische Funktionsmodul verfügt über eine obere und untere Faser-Decklage, über die das Funktionsmodul ganzheitlich an die Oberfläche einer Tragstruktur fest gefügt werden kann. Nachteilhaft bei derartigen eingehausten Funktionsmodulen ist, dass ein relativ dickes Modul keine gute Kraftankopplung vor allem der in der Stapelabfolge oberen Aktorelemente an die Tragstruktur bietet.

Einzelne Aktorelemente können alternativ zu einer Applikation auf die Tragstrukturoberfläche auch in die Tragstruktur integriert werden, um die Kraftankopplung zu verbessern und darüber hinaus den Schutz der einzelnen Aktorelementen gegenüber äußeren mechanischen sowie auch atmosphärischen Einflüssen zu verbessern. Die Integration einzelner oder mehrerer Aktorelemente in einer Tragstruktur bietet sich vornehmlich in jenen Fällen an, in denen die Tragstruktur aus einem Faserverbundwerkstoff gefertigt ist und somit eine Integration der Aktorelemente in die Gewebezwischenlagen der Verbundstruktur leicht möglich ist. Dies setzt jedoch voraus, dass die Applikation bereits während der Herstellung der Tragstruktur erfolgt. Bei möglichen Schadensfällen ist jedoch ein Austausch der in der Tragstruktur integrierten Aktoren nicht möglich oder zumindest nur mit einem großen Aufwand durchzuführen. Darüber hinaus stellt sich zudem das Problem der Recyclingfähigkeit der Tragstruktur, zumal piezoelektrische Materialien häufig giftige Bestandteile, z.B. Bleianteile, enthalten.

Die Druckschrift DE 101 39 686 B4 offenbart einen piezoelektrischen Dehnungsaktuator zur Vibrationsreduzierung in Strukturen, der einen säulenartig ausgebildeten Piezostapel aus einer Vielzahl einzelner Piezoelementen aufweist, dessen Stapellängsrichtung parallel zur Strukturoberfläche orientiert ist. Zur Kraft einleitenden Ankopplung des Dehnungsaktuators an die Strukturoberfläche sind jeweils an sich stirnseitig gegenüberliegenden Enden des Piezostapels winkelförmige Abtriebselemente vorgesehen, die auf der Oberfläche der Struktur befestigt sind. Gleichwohl der bekannte Dehnungsaktuator große Kräfte sowie Biegemomente in die Struktur einzuleiten vermag, bedingt die mechanische Ankopplung eine relativ große Anzahl von Einzelteilen, durch die wiederum die Krafteinleitung verschlechtert und zudem die Empfindlichkeit der Aktuatoranordnung gegen mögliche Fehlbelastungen erhöht wird.

Der Druckschrift DE 10 2010 051 261 A1 ist ein Verfahren zur Erzeugung von 3-dimensional drapierfähigen Duroplast-Funktionselement-Halbzeugen zur Integration in Faser-Duroplast-Verbunde zu entnehmen, bei dem ein Funktionselement in ein unvollständig vernetztes Harzbett auf- bzw. eingelegt wird und durch die dem Harzbett innewohnende Klebrigkeit flächig fixiert wird. Anschließend wird die Oberfläche des Harzbettes samt des darauf aufliegenden Funktionselementes mit Harz vergossen, so dass nach Erstarren und vollständiger Vernetzung der Harzmatrix ein vollständig mit Harz umkapseltes Funktionselement erhalten wird.

Die Druckschrift DE 10 2006 043 015 A1 beschreibt ein Verfahren zur Herstellung eines Folienmoduls, das einen direkten Verbund zwischen einem Funktionswerkstoff und einem Polymerträger aufweist, der im Wege eine Spritzgießprozesses gewonnen wird. Die Anbringung des Folienmoduls auf einen Träger erfolgt konventionell mittels Klebe- und/oder Kraft- und/oder Formschlußverbindung.

Die Druckschrift EP 1 324 402 A1 offenbart eine elektroaktive Vorrichtung mit einer piezoelektrischen Schicht, die in einem Flächenverbund mit einer Vorspannungsschicht steht, durch die die piezoelektrische Schicht komprimiert wird. Die Vorspannungsschicht besteht aus einer ein Verstärkungsmaterial aufweisenden Klebstoffschicht. Die elektroaktive Vorrichtung kann im Wege eines Vakuumverfahrens vermittels eines Hochtemperaturschichtmaterials an eine Oberfläche einer Struktur gefügt werden.

Die Druckschrift CN 103 591 872 A offenbart eine Anordnung zur Beeinflussung und Detektion einer Tragstruktur in Form einer Betonstruktur, insbesondere eine Stahlbetonbrücke, an deren Betonoberfläche ein piezoelektrischer Aktor angeordnet ist, der mittels eines Epoxy-Kohlefaserverbundes an der Betonoberfläche befestigt ist, wobei der Kohlefaserverbund den Aktor überlappt und mit der Betonoberfläche eine feste Fügeverbindung eingeht.

In ähnlicher Weise offenbart die Druckschrift US 5,552,656 die Anhaftung eines Piezoaktors an der Außenwand eines Schiffrumpfes zu dessen Schwingungsanregung, um Bordwandablagerungen, bspw. in Form von Algen etc., zu vermeiden. Auch in diesem Fall haftet ein Piezoaktor vermittels eines den Aktor flächig überragenden Faserverbundwerkstoffes an der Bordwand an.

Die Druckschrift US 2008/9292664 A1 offenbart eine Anordnung gemäß dem Oberbegriff von Anspruch 1, insbesondere einen Laminat-Aktorstapel, bei dem in einem Verbund übereinander gestapelte Piezoaktoren angeordnet sind. Die einzelnen Faserlagen innerhalb des Laminat-Aktorstapels schließen randseitig jeweils bündig miteinander ab.

### Darstellung der Erfindung

Der Erfindung liegt die Aufgabe zugrunde, eine Anordnung zur Beeinflussung und/oder Detektion einer dynamischen oder statischen Eigenschaft einer Tragstruktur die über eine Tragstrukturoberfläche verfügt, mit zumindest einem flächig ausgebildeten ersten Aktorelement, das wenigstens ein elektrisch und/oder magnetisch aktivierbares Wandlermaterial aufweist, sowie einem das erste Aktorelement flächig mittel- oder unmittelbar an die Tragstrukturoberfläche fügenden Faserverbundwerkstoff mit wenigstens einer ersten Faserschicht und einer aushärtbaren Matrix, derart weiterzubilden, dass die mechanische Ankopplung zwischen dem wenigstens einen Aktorelement und der Tragstrukturoberfläche und damit verbunden die Kraft- und Biegemoment-Übertragung zwischen dem wenigstens einen Aktorelement und der Tragstrukturoberfläche verbessert werden soll. Dies soll insbesondere auch für jene Aktorelemente gelten, die im Wege einer Vielzahl übereinander angeordneter Aktorelemente mit jeweils zwischenliegend angeordneten Faserschichten in Form einer Stapelanordnung einen größeren Abstand zur Tragstrukturoberfläche aufweisen, als das unmittelbar oder mittelbar an der Tragstrukturoberfläche aufliegende erste Aktorelement.

Die Lösung der der Erfindung zugrundeliegenden Aufgabe ist im Anspruch 1 angegeben. Den Erfindungsgedanken in vorteilhafter Weise weiterbildende Merkmale sind Gegenstand der Unteransprüche sowie der weiteren Beschreibung unter Bezugnahme auf die Figuren zu entnehmen.

Die Lösung geht von einer Anordnung zur Beeinflussung und/oder Detektion einer dynamischen oder statischen Eigenschaft einer Struktur aus, bei der die erste Faserschicht das mittel- oder unmittelbar an der Tragstrukturoberfläche anliegende erste Aktorelement zumindest teilweise überdeckt. Die teilweise Überdeckung der ersten Faserschicht zeichnet sich dadurch aus, dass die erste Faserschicht das erste Aktorelement längs wenigstens einer parallel zur Tragstrukturoberfläche orientierten Raumrichtung beidseitig überragt und zumindest in den das erste Aktorelemente überragenden Bereichen der Faserschicht zumindest bereichsweise unmittelbar an der Tragstrukturoberfläche vermittels der aushärtbaren Matrix fest anhaftet. Auf diese Weise ist sichergestellt, dass deformationsbedingte Kräfte, sei es durch eine Deformation der Tragstrukturoberfläche oder des Aktorelementes, längs der Faserschicht direkt zwischen dem Aktorelement und der Tragstruktur übertragen werden können, zumal die Faserschicht mittels der vorzugsweise aus einem aushärtbaren Harzmaterial bestehenden Matrix sowohl mit dem flächigen Aktorelement als auch mit der Tragstrukturoberfläche festgefügt ist.

Der Begriff "Faserschicht" umfasst in einer einfachsten Ausführungsform zumindest ein unidirektional verlaufendes Faserbündels oder ein unidirektionales Gelege bestehend aus einzelnen Faser, das zur bidirektionalen Übertragung von Kräften längs der einzelnen Fasern geeignet ist. Die Fasern besitzen dabei eine Länge, so dass die Fasern das wenigstens eine Aktorelement längs der parallel zur Tragstrukturoberfläche orientierten Raumrichtung beidseitig überragen und beidseitig fest an der Tragstrukturoberfläche vermittels der Matrix anhaften. Derartige unidirektionale Gelege werden auch als UD-Schichten bezeichnet. Besonders bevorzugte ist die Verwendung von geflochtenen Fasern, in Form von Fasergewebematten -oder schichten, die zur Übertragung von Kräften längs der lateralen Erstreckung der Fasergewebeschicht geeignet sind.

Unter einem "flächig ausgebildeten Aktorelement" wird eine Raumform der Aktors verstanden, die sich durch eine flächige, d.h. laterale Erstreckung, sowie durch ein orthogonal zur lateralen Erstreckung orientiertes Dickenmaß auszeichnet, wobei das Dickenmaß sehr viel kleiner bemessen ist als die laterale Erstreckung. Synonyme Formulierungen stellen bspw. plättchenartig oder plattenartig ausgebildete Aktorelemente dar. Nicht notwendigerweise müssen die flächig ausgebildeten Aktorelement eben ausgebildet sein. So sind durchaus auch flächig gekrümmte oder gebogene Aktorelemente denkbar, insbesondere in Fällen, in denen die Tragstrukturoberfläche selbst räumlich gekrümmt ist.

Die erste Faserschicht, im Sinne eines unidirektionalen Fasergeleges oder einer Fasergewebeschicht, überdeckt das mittel- oder unmittelbar auf der Tragstrukturoberfläche aufliegende, flächige Aktorelement zumindest brückenartig, wobei die Faserschicht an zwei dem ersten Aktorelement gegenüberliegenden Flächenbereichen fest mit der Tragstrukturoberfläche gefügt ist. Die Längserstreckung der das Aktorelement zumindest brückenartig überragende Faserschicht orientiert sich vorzugsweise längs der Hauptdeformationsrichtung des Aktorelementes, um so möglichst verlustfrei die Transformationseigenschaften des Wandlermaterials des Aktorelementes nutzen zu können.

Vorzugsweise deckt die erste Faserschicht in Form einer Fasergewebeschicht das mittel- oder unmittelbar auf der Tragstrukturoberfläche aufliegende erste Aktorelement vollständig ab und überragt das Aktorelement längs seiner gesamten Umfangsrandes, so dass die die erste Fasergewebeschicht vermittels der aushärtbaren Matrix fest an der Tragstrukturoberfläche anhaftet und das Aktorelement gemeinsam mit der Tragstrukturoberfläche vollständig umfasst. Hierdurch können sämtliche auftretende Deformationen und Biegemomente über die Fasergewebeschicht zwischen dem flächigen Aktorelement und der Tragstrukturoberfläche übertragen werden.

Lösungsgemäß ist eine zweite Schichtabfolge, zumindest umfassend ein zweites flächig ausgebildetes Aktorelement sowie eine zweite Faserschicht, vorzugsweise in Form einer Fasergewebeschicht, unmittelbar oder mittelbar auf der das erste Aktorelement zumindest teilweise überdeckenden ersten Fasergewebeschicht flächig, fest gefügt. Die zweite Fasergewebeschicht überdeckt das zweite Aktorelement zumindest teilweise und überragt das zweite Aktorelement sowie die erste Fasergewebeschicht zumindest längs der wenigstens einen parallel zur Tragstrukturoberfläche orientierten Raumrichtung beidseitig und haftet in diesen Bereichen mittels der aushärtbaren Matrix unmittelbar fest an der Tragstrukturoberfläche an.

Vermittels der zweiten Fasergewebeschicht, die gleichsam der ersten Fasergewebeschicht zumindest in ihren peripheren Randbereichen direkt auf der Tragstrukturoberfläche aufliegt und vermittels der aushärtbaren Matrix fest mit dieser verbunden ist, können Kräfte und Biegemomente zwischen dem zweiten flächig ausbildeten Aktorelement und der Tragstrukturoberfläche direkt übertragen werden.

In gleicher Weise lässt sich die lösungsgemäße Anordnung durch stapelförmiges übereinander Anordnen einer beliebigen Vielzahl weiterer Schichtabfolgen, jeweils umfassend wenigstens ein flächig ausgebildetes Aktorelement sowie eine Fasergewebeschicht, auf die vorstehend erläuterte zweite Fasergewebeschicht erweitern. Dabei gilt es zu beachten, dass jede den einzelnen Schichtabfolgen jeweils zugeordnete Fasergewebeschicht zumindest bereichsweise an ihrem Randbereich unmittelbar an der Tragstrukturoberfläche aufliegt und vermittels der aushärtbaren Matrix fest anhaftet.

Jede einzelne Fasergewebeschicht ist dabei so gestaltet, dass ein direkter Kontakt zur Tragstrukturoberfläche hergestellt ist, so dass eine direkte Kraftübertragung zwischen der Tragstrukturoberfläche und dem der jeweiligen Schichtabfolge zugeordneten Aktorelement gesichert ist. Hierdurch wird insbesondere für die in der übereinander gestapelten Schichtabfolge oberen flächigen Aktorelementen, die sich weiter von der Tragstrukturoberfläche entfernt befinden, eine effektive Kraftübertragung zwischen den einzelnen Aktorelementen und der Tragstrukturoberfläche gewährleistet.

In vorteilhafter Weise bestehen die einzelnen Faserschichten aus einem elektrisch nicht leitenden Material, vorzugsweise aus Glas- oder Kunstfasern, so dass eine elektrische Isolierung zwischen den einzelnen vorzugsweise piezoelektrischen Aktorelementen besteht. Jedoch ist der Einsatz von elektrisch leitenden Fasermaterialien, wie bspw. Kohlefasern in Fällen denkbar, in denen eine durch die Fasern erforderliche elektrische Isolierung nicht erforderlich ist.

Neben der Verwendung von piezoelektrischem oder piezokeramischen Material sind ebenso alternative Wandlermaterialien zur Realisierung des wenigstens einen Aktorelementes denkbar, wie beispielsweise magnetostriktive oder elektrostriktive Materialien, piezoelektrische Keramiken. Ebenso ist auch die Verwendung von Formgedächtnislegierungen denkbar.

In einer weiteren bevorzugten Ausführungsform, die eine Vielzahl übereinander angeordnete Aktorelemente mit jeweils zwischenliegenden Faserschichten vorsieht, sind die Aktorelemente in Form und Größe identisch ausgebildet und jeweils fluchtend übereinander angeordnet. Vorzugsweise weisen zusätzlich die einzelnen als Fasergewebeschichten ausgebildeten Faserschichten über aufeinander abgestimmte Faserorientierungen auf, vorzugsweise sind diese untereinander gleichorientiert angeordnet. Die Faserorientierungen sind vor allem auch unter Berücksichtigung der Hauptdeformationsrichtung betreffend das wenigstens eine Aktorelement und/oder das dynamische Verhalten der Tragstruktur geeignet zu wählen.

Je nach Größe der Tragstruktur sowie der durch die Aktoranordnung aufzubringenden Aktorkräfte, um einer wirksame Deformation der Tragstruktur zu erzielen, sind Ausführungsbeispiele denkbar, bei denen zwei und mehr Aktorelemente pro Schicht nebeneinander angeordnet sind. Auch in diesem Fall überragt jede einzelne, den Aktorelementen pro Schicht zugeordnete Faserschicht sämtliche in der Schicht angeordnete Aktorelemente und vermag Kräfte zwischen den Aktorelementen und der Tragstruktur direkt zu übertragen.

Der Ausbildung und Anordnung der vorzugsweise eine Vielzahl übereinander angeordneter flächig ausgebildeter Aktorelemente, mit den diesen jeweils zugeordneten Faserschichten, die jeweils einzeln in unmittelbarem Kontakt mit der Tragstrukturoberfläche stehen, liegt ein bevorzugtes Verfahrensprinzip zugrunde, bei dem die zwischen der Tragstrukturoberfläche und den einzelnen Aktorelementen wirkenden Kräfte und Biegemomente jeweils direkt längs der den Aktorelementen zugeordneten Fasergewebeschichten übertragen werden. Durch diese direkte Kraftübertragung kann eine effektive Beeinflussung der dynamischen sowie auch statischen Eigenschaften der Tragstruktur realisiert werden unter optimaler Ausnutzung der den einzelnen Aktorelementen zueigenen Transformationseigenschaften. Die optimale Ausnutzung kommt insbesondere jenen Aktorelementen zugute, die in der Stapelanordnung am weitesten von der Tragstrukturoberfläche entfernt angeordnet sind.

Die lösungsgemäße Anordnung lässt sich an nahezu allen frei zugänglichen Tragstrukturoberflächen anbringen, um eine gezielte Schwingungsbeeinflussung, d.h. dynamische Beeinflussung, und/oder Größen- bzw. Geometriebeeinflussung einer Tragstruktur, d.h. statische Beeinflussung zu ermöglichen. So ermöglicht die lösungsgemäße Anordnung aufgrund ihrer kontrollierbaren und aufeinander abgestimmte Geometrie- bzw. Längenänderung aller in der Stapelanordnung enthaltenen Aktorelemente eine aktive Veränderung der Tragstrukturgeometrie. Derartige Längenänderungen sind bspw. zum Ausgleich von thermisch induzierten Längenänderungen oder zur Geometrieänderung aerodynamisch wirksamer flächiger Bauteile von großem Nutzen.

Auch dient die lösungsgemäße Anordnung zur Schadensdetektion einer Tragstruktur, bei der die einzelnen Aktorelemente jeweils als Sensoren betrieben werden. In vorteilhafter Weise lässt sich die lösungsgemäße Anordnung an Strukturen im Bereich des Automobilbaus, der Luftfahrt, des Maschinenbaus oder der Architektur anbringen und einsetzen.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1: Schematisierte Schnittzeichnung durch eine lösungsgemäß ausgebildete Anordnung mit einer Vielzahl übereinander gefügter, flächig ausgebildeter Aktorelemente sowie
- Fig. 2: Alternative Anordnung mit einer Vielzahl übereinander gefügter, flächig ausgebildeter Aktorelemente, jeweils innerhalb einer Fasergewebeschicht.

### Wege zur Ausführung der Erfindung, gewerbliche Verwendbarkeit

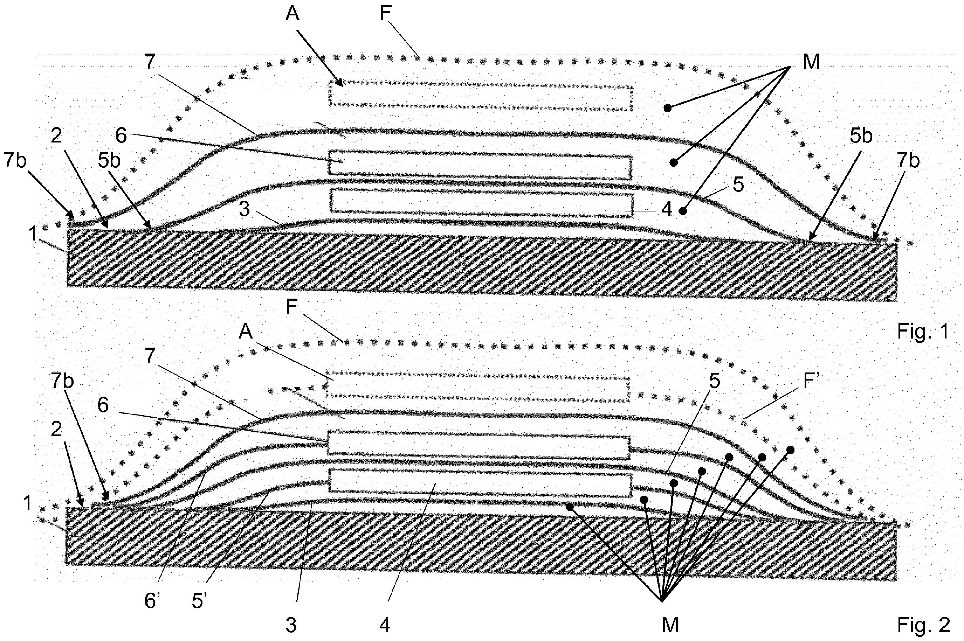

Figur 1 zeigt eine Schnittdarstellung durch eine lösungsgemäß ausgebildete Anordnung zur Beeinflussung der dynamischen Eigenschaften einer Tragstruktur 1, mit einer frei zugänglichen Tragstrukturoberfläche 2. Auf der Tragstrukturoberfläche 2 ist zu Zwecken einer elektrischen Isolation eine unterste Faserschicht in Form einer Fasergewebeschicht 3, vorzugsweise eine Glasfasergewebeschicht, aufgebracht, auf der ein erstes flächig ausgebildetes Aktorelement 4 aufliegt. Das Aktorelement 4, das vorzugsweise ein plättchenförmig ausgebildetes piezoelektrisches Element ist, weist eine Ober- und Unterseite auf, die parallel zur Tragstrukturoberfläche 2 orientiert sind. Über das erste Aktorelement 4 ist eine erste Fasergewebeschicht 5 angeordnet, die sowohl das erste Aktorelement 4 als auch die unmittelbar darunter liegenden Faserschicht 3 lateral, d.h. seitlich zur Tragstrukturoberfläche 2 überragt. Somit weist die erste Fasergewebeschicht 5 Bereiche 5b auf, die unmittelbar an der Tragstrukturoberfläche 2 aufliegen. Vermittels einer aushärtbaren Matrix M, vorzugsweise in Form eines aushärtbaren Harzes, die zumindest das erste Aktorelement 4 umgibt sowie zumindest die Fasergewebeschichten 3 und 5 durchdringt, haftet die erste Fasergewebeschicht 5 in den Bereichen 5b unmittelbar an der Tragstrukturoberfläche 2 fest an.

Auf der ersten Fasergewebeschicht 5 ist des Weiteren ein zweites flächig ausgebildetes Aktorelement 6 angebracht, das vorzugsweise in Form und Größe identisch mit dem ersten Aktorelement 4 ausgebildet ist. Über dem zweiten Aktorelement 6 ist eine zweite Fasergewebeschicht 7 angeordnet, die sowohl das zweite Aktorelement 6 sowie auch die erste Fasergewebeschicht 5 lateral überragt und Bereiche 7b aufweist, die unmittelbar an der Tragstrukturoberfläche 2 anliegen und vermittels der aushärtbaren Matrix M fest an dieser anhaften.

In gleicher Weise schließt sich eine Vielzahl weiterer derartiger Schichtabfolgen, jeweils umfassend ein Aktorelement A sowie eine dazugehörige Fasergewebeschicht F in übereinander folgender Stapelweise über der zweiten Fasergewebeschicht 7 an. Dies ist durch die jeweils punktierte Linienführung betreffend das Aktorelement A sowie die Fasergewebeschicht F versinnbildlicht.

Sämtliche Fasergewebeschichten F sowie auch Aktorelemente A sind von einer aushärtbaren Matrix M umgeben bzw. von dieser durchdrungen. Jede einzelne Fasergewebeschicht F, die jeweils unmittelbar über einem Aktorelement A angeordnet ist, tritt mit ihrem peripheren Randbereich in unmittelbaren Kontakt mit der Tragstrukturoberfläche 2, so dass Kräfte sowie auch Biegemomente bidirektional zwischen der Tragstrukturoberfläche 2 und dem jeweiligen Aktorelement A direkt übertragen werden können. Dies verleiht der schichtförmigen Anordnung die Eigenschaft, dass insbesondere jene Aktorelemente A, die in der Stapelanordnung am weitesten von der Tragstrukturoberfläche 2 entfernt liegen, direkt kraftschlüssig mit der Tragstrukturoberfläche verbunden sind, so dass die durch Deformationen hervorgerufenen Kräfte längs der jeweiligen Fasergewebeschicht F nahezu verlustfrei zwischen der Tragstrukturoberfläche 2 und dem Aktorelement A übertragen werden können.

Eine weitere Variante der lösungsgemäßen Anordnung ist in Figur 2 dargestellt, bei der zusätzlich zu den vorstehend beschriebenen ersten und zweiten Fasergewebeschichten 5, 7 sowie weiteren Fasergewebeschichten F, weitere Zwischen-Fasergewebeschichten 5', 6', F' in die Stapelanordnung eingebracht sind, die jeweils passend zu den einzelnen Aktorelementen 4, 6, A, Ausnehmungen vorsehen, in die die Aktorelemente passgenau eingesetzt sind und diese an ihrem Umfangsrand jeweils nahtlos umfassen. Durch die zusätzlichen Zwischen-Fasergewebeschichten 5', 6', F' ist eine weitere Verbesserung in der Kraftübertragung im Vergleich zu dem in Figur 1 dargestellten Ausführungsbeispiel zwischen den Aktorelementen und der Tragstrukturoberfläche möglich, zumal auch die Zwischen-Fasergewebeschichten 5', 6', F' an ihren peripheren Randbereichen mit der Tragstrukturoberfläche 2 fest verbunden sind.

Die lösungsgemäße Anordnung zur unmittelbaren Beeinflussung der dynamischen Eigenschaften einer Tragstruktur ist mit einer Vielzahl von Vorteilen verbunden:
Optimierte mechanische Ankopplung sämtlicher Aktorelemente an die Tragstruktur über zumindest eine den jeweiligen Aktorelementen zugeordnete Fasergewebeschicht, die mit der Tragstruktur direkt haft- und kraftschlüssig verbunden ist.

Durch die Anordnung sämtlicher Aktorelemente auf und damit oberhalb der Tragstrukturoberfläche ist eine Ankopplung der lösungsgemäßen Anordnung außerhalb der neutralen Faser der Tragstruktur zum Zwecke einer effektiven Erzeugung von auf die Tragstruktur einwirkenden Biegemomenten möglich.

Sämtliche in der Anordnung integrierte Aktorelemente sind gegenüber äußeren Umwelteinflüssen durch den Faserverbundwerkstoff bzw. durch die Matrix M geschützt.

Gegenüber einer integralen Anordnung von Aktorelementen innerhalb einer Tragstruktur lässt sich die lösungsgemäße Anordnung leichter und daher kostengünstiger herstellen, zumal diese lediglich eine oberflächliche Applikation darstellt. Grundsätzlich lässt sich die lösungsgemäße Anordnung auf sämtliche Tragstrukturen anbringen, so insbesondere auch an metallische Tragstrukturoberflächen.

Ein Austausch im Falle defekter Aktorelemente ist leicht und kostengünstig möglich.

Die Recyclingfähigkeit gegenüber einer integralen Ausbildungsform ist bei der lösungsgemäßen Anordnung gegeben, zumal piezoelektrische Materialien zumeist giftiges Material, wie beispielsweise Blei, enthalten.

Letztlich ist die Schadenstoleranz der lösungsgemäßen Anordnung hervorzuheben, zumal ein Versagen einzelner Aktorelemente nicht zum Ausfall der gesamten Anordnung führt.

### Bezugszeichenliste

- 1: Tragstruktur
- 2: Tragstrukturoberfläche
- 3: Unterste Fasergewebeschicht
- 4: Erstes Aktorelement
- 5: Erste Fasergewebeschicht
- 5b: Periphere Bereiche der ersten Fasergewebeschicht
- 5': Zwischen-Fasergewebeschicht
- 6: Zweites flächiges Aktorelement
- 6': Zwischen-Fasergewebeschicht
- 7: Zweite Fasergewebeschicht
- 7b: Periphere Bereiche der zweiten Fasergewebeschicht
- M: Matrix
- A: Weitere Aktorelemente
- F: Weitere Fasergewebeschicht

## Patentansprüche

1. Anordnung zur Beeinflussung und/oder Detektion einer dynamischen oder statischen Eigenschaft einer Tragstruktur (1), die über eine Tragstrukturoberfläche (2) verfügt, mit zumindest einem flächig ausgebildeten ersten Aktorelement (4), das wenigstens ein elektrisch und/oder magnetisch aktivierbares Wandlermaterial aufweist, sowie einem das erste Aktorelement (4) flächig mittel- oder unmittelbar an die Tragstrukturoberfläche (2) fügenden Faserverbundwerkstoff, der zumindest eine erste Faserschicht (5) sowie eine aushärtbare Matrix (M) aufweist, wobei die erste Faserschicht (5)
a) das mittel- oder unmittelbar an der Tragstrukturoberfläche (2) anliegende erste Aktorelement (4) zumindest teilweise überdeckt,
b) das erste Aktorelement (4) längs wenigstens einer parallel zur Tragstrukturoberfläche (2) orientierten Raumrichtung beidseitig überragt, und
c) zumindest in das erste Aktorelement (4) überragenden Bereichen (5b) zumindest bereichsweise unmittelbar an der Tragstrukturoberfläche (2) vermittels der aushärtbaren Matrix (M) fest anhaftet, und
eine zweite Schichtabfolge, zumindest umfassend ein zweites Aktorelement (6) sowie eine zweite Faserschicht (7), unmittelbar oder mittelbar auf der das erste Aktorelement (4) überdeckenden ersten Faserschicht (5) flächig fest gefügt ist,
wobei die zweite Faserschicht (7) das zweite Aktorelement (6) zumindest teilweise überdeckt, dieses zumindest längs der wenigstens einen parallel zur Tragstrukturoberfläche (2) orientierten Raumrichtung beidseitig überragt, und zumindest in das zweite Aktorelement (6) überragenden Bereichen (7b) zumindest bereichsweise unmittelbar an der Tragstrukturoberfläche (2) vermittels der aushärtbaren Matrix (M) fest anhaftet,
**dadurch gekennzeichnet, dass** die zweite Faserschicht (7) auch die erste Faserschicht (5) zumindest längs der wenigstens einen parallel zur Tragstrukturoberfläche (2) orientierten Raumrichtung beidseitig überragt, und zumindest in den das zweite Aktorelement (6) sowie die erste Faserschicht (5) überragenden Bereichen (7b) zumindest bereichsweise unmittelbar an der Tragstrukturoberfläche (2) vermittels der aushärtbaren Matrix (M) fest anhaftet.

2. Anordnung nach Anspruch 1,
**dadurch gekennzeichnet, dass** unmittelbar oder mittelbar auf die zweite Schichtabfolge eine beliebige Anzahl weiterer Schichtabfolgen, zumindest umfassend jeweils ein Aktorelement (A) sowie eine Faserschicht (F), gleichsam der zweiten Schichtabfolge, flächig fest gefügt ist, wobei jede den einzelnen Schichtabfolgen zugeordnete Faserschicht (F) jeweils bereichsweise unmittelbar an der Tragstrukturoberfläche (2) vermittels der aushärtbaren Matrix (M) fest anhaftet.

3. Anordnung nach Anspruch 1 oder 2,
**dadurch gekennzeichnet, dass** die das wenigstens eine Aktorelement (4) überdeckende erste Faserschicht (5) mit dem Aktorelement (4) vermittels der aushärtbaren Matrix (M) in einem festen, flächigen Fügeverbund derart steht, so dass das Aktorelement (4) längs der ersten Faserschicht (5) mit der Tragstrukturoberfläche (2) in direkter Wirkverbindung steht.

4. Anordnung nach Anspruch 2 und 3,
**dadurch gekennzeichnet, dass** die Faserschicht (F) sowie das Aktorelement (A) jeder Schichtabfolge vermittels der aushärtbaren Matrix (M) in einem festen, flächigen Fügeverbund derart stehen, so dass pro Schichtabfolge das Aktorelement (A) längs der Faserschicht (F) mit der Tragstrukturoberfläche (2) in direkter Wirkverbindung steht.

5. Anordnung nach einem der Ansprüche 1 bis 4,
**dadurch gekennzeichnet, dass** die Faserschicht (5, 7, F) eine Fasergewebeschicht ist.

6. Anordnung nach einem der Ansprüche 1 bis 5,
**dadurch gekennzeichnet, dass** das Wandlerelement des Aktorelementes (4, 6, A) wenigstens ein Material der nachstehenden Art umfasst: Piezoelektrische oder, piezokeramische Materialien.

7. Anordnung nach einem der Ansprüche 2 bis 6,
**dadurch gekennzeichnet, dass** die Aktorelemente (A) sämtlicher Schichtabfolgen in Form und Größe identisch und in Art einer Stapelanordnung fluchtend übereinanderliegend angeordnet sind.

8. Verwendung einer Anordnung nach einem der Ansprüche 1 bis 7 zur Schwingungsbeeinflussung einer Tragstruktur (1).

9. Verwendung einer Anordnung nach einem der Ansprüche 1 bis 7 zur Schadensdetektion einer Tragstruktur (1).

10. Verwendung nach Anspruch 8 oder 9,
**dadurch gekennzeichnet, dass** die Tragstruktur (1) eine Struktur im Bereich des Automobilbaus, der Luftfahrt, des Maschinenbaus oder der Architektur ist.

## Claims

1. Arrangement for influencing and/or detecting a dynamic or static property of a support structure (1) having a support structure surface (2), said arrangement comprising at least one planar first actuator element (4) that includes at least one electrically and/or magnetically activated transducer material, and comprising a fibre composite material which joins the first actuator element (4) in a planar manner directly or indirectly to the support structure surface (2) and which has at least a first fibre layer (5) and a curable matrix (M), wherein the first fibre layer (5)
a) at least partly covers the first actuator element (4) resting directly or indirectly on the support structure surface (2),
b) protrudes beyond the first actuator element (4) on both sides along at least one spatial direction running parallel to the support structure surface (2), and
c) at least in regions (5b) protruding into the first actuator element (4), permanently adheres directly to at least some areas of the support structure surface (2) by means of the curable matrix (M), and
a second layer sequence, comprising at least one second actuator element (6) and one second fibre layer (7), which is permanently joined in planar manner indirectly or directly to the first fibre layer (5) that covers the first actuator element (4); wherein
the second fibre layer (7) at least partially covers the second actuator element (6), protrudes on both sides thereof at least along the at least one spatial direction running parallel to the support structure surface (2), and
at least in regions (7b) protruding into the second actuator element (6), permanently adheres directly to at least some areas of the support structure surface (2) by means of the curable matrix (M),
**characterized in that** the second fibre layer (7) also protrudes beyond the first fibre layer (5) on both sides, at least along the at least one spatial direction running parallel to the support structure surface (2), and at least in the regions (7b) protruding beyond the second actuator element (6) and the first fibre layer (5), permanently adheres directly to at least some areas of the support structure surface (2) by means of the curable matrix (M).

2. Arrangement according to Claim 1,
**characterized in that** any number of further layer sequences, each comprising at least one actuator element (A) and one fibre layer (F), is permanently joined directly or indirectly in planar manner to the second layer sequence, similarly to the second layer sequence, wherein each fibre layer (F) assigned to the individual layer sequences permanently adheres directly to at least some areas of the support structure surface (2) by means of the curable matrix (M).

3. Arrangement according to Claim 1 or 2,
**characterized in that** the first fibre layer (5) covering the at least one actuator element (4) is in a permanent, planar joining bond with the actuator element (4) via the curable matrix (M) in such manner that the actuator element (4) is in direct operative connection with the support structure surface (2) along the first fibre layer (5).

4. Arrangement according to Claim 2 and 3,
**characterized in that** the fibre layer (F) and the actuator element (A) of each layer sequence are in a permanent, planar joining bond via the curable matrix (M) in such manner that the actuator element (A) is in direct operative connection with the support structure surface (2) along the fibre layer (F) for each layer sequence.

5. Arrangement according to any one of Claims 1 to 4,
**characterized in that** the fibre layer (5, 7, F) is a fibre fabric layer.

6. Arrangement according to any one of Claims 1 to 5,
**characterized in that** the transducer element of the actuator element (4, 6, A) comprises at least one material of the following kind: piezoelectric or piezoceramic materials.

7. Arrangement according to any one of Claims 2 to 6,
**characterized in that** the actuator elements (A) of all layer sequence are identical in shape and size, and are arranged to lie flush, one on top of the other in the manner of a stack formation.

8. Use of an arrangement according to any one of Claims 1 to 7 for influencing the vibration of a support structure (1).

9. Use of an arrangement according to any one of Claims 1 to 7 for detecting damage to a support structure (1).

10. Use according to Claim 8 or 9,
**characterized in that** the support structure (1) is a structure in the field of automobile construction, aviation, machine building or architecture.

## Revendications

1. Agencement pour influencer et/ou détecter une propriété dynamique ou statique d'une structure porteuse (1), qui dispose d'une surface de structure porteuse (2), comportant au moins un premier élément d'actionnement planaire (4), qui présente au moins un matériau convertisseur électriquement et/ou magnétiquement activable, ainsi qu'un matériau composite fibreux qui joint le premier élément d'actionnement (4) directement ou indirectement à la surface de la structure porteuse (2), qui présente au moins une première couche fibreuse (5) et une matrice durcissable (M), dans lequel le première couche fibreuse (5)
a) recouvre au moins partiellement le premier élément d'actionnement (4) se trouvant directement ou indirectement sur la surface de la structure porteuse (2),
b) le premier élément d'actionnement (4) s'élève des deux côtés le long d'au moins une direction spatiale parallèle à la surface de la structure porteuse (2), et
c) au moins dans le premier élément d'actionnement (4), des zones en saillie (5b) adhèrent fermement au moins dans certaines zones directement à la surface de la structure porteuse (2) au moyen de la matrice durcissable (M), et
une deuxième séquence de couches, comprenant au moins un deuxième élément d'actionnement (6) et une deuxième couche fibreuse (7), qui est solidarisée directement ou indirectement à la première couche fibreuse (5) recouvrant le premier élément d'actionnement (4),
dans lequel la deuxième couche fibreuse (7) recouvre au moins partiellement le deuxième élément d'actionnement (6), celui-ci s'élève des deux côtés au moins le long de la direction spatiale orientée au moins parallèlement à la surface de structure porteuse (2),
et au moins dans le deuxième élément d'actionnement (6) des zones (7b) adhèrent fermement dans des zones directement sur la surface de structure porteuse (2) au moyen de la matrice durcissable (M),
**caractérisé en ce que** la deuxième couche fibreuse (7) ainsi que la première couche fibreuse (5) s'élève également des deux côtés, au moins le long de la au moins une direction spatiale orientée parallèlement à la surface de structure porteuse (2), et au moins dans les zones (7b) dépassant en saillie sur le deuxième élément d'actionnement (6) et la première couche fibreuse (5), adhère fermement au moins dans certaines zones directement sur la surface de structure porteuse (2) au moyen de la matrice durcissable (M).

2. Agencement selon la revendication 1,
**caractérisé en ce que** directement ou indirectement sur la deuxième séquence de couches n'importe quel nombre de séquences de couches supplémentaires, chacune comprenant au moins un élément d'actionnement (A) et une couche fibreuse (F), en quelque sorte la deuxième séquence de couches, sont fermement jointes, dans lequel chaque couche fibreuse (F) associée à des séquences de couches individuelles dans chaque zone adhère directement à la surface de la structure porteuse (2) au moyen de la matrice durcissable (M).

3. Agencement selon la revendication 1 ou 2, **caractérisé en ce que** la première couche fibreuse (5) recouvrant le au moins un élément d'actionnement (4) est en liaison fixe et plane avec l'élément d'actionnement (4) au moyen de la matrice durcissable (M), de telle sorte que l'élément d'actionnement (4) le long de la première couche fibreuse (5) soit en liaison opérationnelle directe avec la surface de la structure porteuse (2).

4. Agencement selon les revendications 2 et 3,
**caractérisé en ce que** la couche fibreuse (F) et l'élément d'actionnement (A) de chaque séquence de couches sont en liaison fixe et plane au moyen de la matrice durcissable (M), de telle sorte que l'élément d'actionnement pour chaque séquence de couches (A) le long de la couche fibreuse (F) soit en liaison opérationnelle directe avec la surface de la structure porteuse (2).

5. Agencement selon une des revendications 1 à 4,
**caractérisé en ce que** la couche fibreuse (5, 7, F) est une couche de tissu fibreux.

6. Agencement selon une des revendications 1 à 5,
**caractérisé en ce que** l'élément convertisseur de l'élément d'actionnement (4, 6, A) comprend au moins un matériau du type suivant : matériaux piézoélectriques ou piézocéramiques.

7. Agencement selon une des revendications 2 à 6,
**caractérisé en ce que** les éléments actionneurs (A) de toutes les séquences de couches ont identiques en forme et en taille et disposés en alignement l'un au-dessus de l'autre à la manière d'un empilement.

8. Utilisation d'un agencement selon une des revendications 1 à 7 pour influencer la vibration d'une structure porteuse (1).

9. Utilisation d'un agencement selon une des revendications 1 à 7 pour la détection de l'endommagement d'une structure porteuse (1).

10. Utilisation selon la revendication 8 ou 9,
**caractérisée en ce que** la structure porteuse (1) est une structure dans le domaine de l'ingénierie automobile, l'aviation, l'ingénierie mécanique ou l'architecture.
